(19) Europäisches Patentamt

European Patent Office

Office européen des brevets

(11) **EP 1 063 766 A2**

(12) **EUROPÄISCHE PATENTANMELDUNG**

(43) Veröffentlichungstag:
27.12.2000 Patentblatt 2000/52

(51) Int. Cl.⁷: **H03C 3/09**

(21) Anmeldenummer: **00111572.4**

(22) Anmeldetag: **30.05.2000**

(84) Benannte Vertragsstaaten:
**AT BE CH CY DE DK ES FI FR GB GR IE IT LI LU MC NL PT SE**
Benannte Erstreckungsstaaten:
**AL LT LV MK RO SI**

(30) Priorität: **25.06.1999 DE 19929167**

(71) Anmelder:
**Infineon Technologies AG**
**81541 München (DE)**

(72) Erfinder: **Märzinger, Günter**
**4161 Ulrichsberg (AT)**

(74) Vertreter:
**Zedlitz, Peter, Dipl.-Inf. et al**
**Patentanwalt,**
**Postfach 22 13 17**
**80503 München (DE)**

(54) **Modulator und Verfahren zur Phasen-oder Frequenzmodulation mit einer PLL-Schaltung**

(57)  Modulator und Verfahren zur Phasen- oder Frequenzmodulation mit einer PLL-Schaltung, wobei die Modulation sowohl an einem Punkt der PLL erfolgt, an dem sich ein Hochpaß-Übertragungsverhalten für die Modulationsfrequenz ergibt, als auch zusätzlich an einem weiteren Punkt der PLL erfolgt, an dem sich ein Tiefpaß-Übertragungsverhalten für die Modulationsfrequenz ergibt, wobei die Modulation mit Tiefpaß-Übertragungsverhalten in einem Frequenz-Teiler im Ruckführungszweig der PLL digital erfolgt.

**FIG 2**

**Beschreibung**

Die vorliegende Erfindung betrifft einen Modulator und ein Verfahren zur Phasen- oder Frequenzmodulation mit einer PLL-(Phase Locked Loop = Nachlaufsynchronisation)-Schaltung, wobei die Modulation sowohl an einem Punkt der PLL-Schaltung erfolgt, an dem sich ein Hochpaß-Übertragungsverhalten für die Modulationsfrequenz ergibt, als auch zusätzlich an einem weiteren Punkt der PLL-Schaltung, an dem sich ein Tiefpaß-Übertragungsverhalten für die Modulationsfrequenz ergibt.

Solche Schaltungen sind bereits aus dem Stand der Technik bekannt, beispielsweise aus den Veröffentlichungen:

P.L. Field et al., "Optimum Loop Bandwidth of Phase-Locked Loop Modulators", IEE Colloquium on "Advanced Modulation and Channel Coding Techniques for Mobile Communication", London 1992, p.7/1-5,

R. A. Meyers, P.H. Waters, "Synthesizer Review for Pan-European Digital Cellular Radio", IEE Symposium on VLSI Implementation for 2nd Generation Cordless and Mobile Communication Systems, 1990, p. 8/1-10 und

S. Grimmet, "Frequency Modulation in a Phase Lack Loop by Control of the Phase Inside the Loop", Frequency Synthesis Handbook, a Collection from RFdesign, 1992, p. 70-73.

Dabei wird an zwei Punkten der PLL, an einem Punkt mit Hochpaß-Verhalten und einem Punkt mit Tiefpaß-Verhalten die Modulation eingebracht. Die beiden Modulationssignale überlagern sich am Ausgang der PLL und man erhält auf diese Weise ein frequenzunabhängiges Übertragungsverhalten der Loop. Das Problem bei den im Stand der Technik dargestellten Lösungen ist die verwendete Methode zum Einbringen des Signals an einem Punkt mit Tiefpaß-Charakteristik. Hierfür war bisher immer analoge Schaltungstechnik zur Signalbearbeitung notwendig. Damit verbunden waren Toleranzprobleme bei der Fertigung und Driftprobleme mit der Temperatur und der Alterung. Aufgrund der Tiefpaß-Charakteristik an diesem Einspeise-Punkt wurden solche Störungen auch nicht durch die PLL reduziert.

Es ist daher Aufgabe der vorliegenden Erfindung, diese Probleme mit Toleranz und Drift an dem Einspeisepunkt mit Tiefpaßverhalten zu vermeiden.

Erfindungsgemäß wird diese Aufgabe durch einen Modulator gelöst, bei dem die Modulation mit Tiefpaß-Übertragungsverhalten in einem Frequenzteiler im Rückfuhrungszweig der PLL-Schaltung digital erfolgt. Ebenso wird die Aufgabe der vorliegenden Erfindung durch ein entsprechendes Verfahren gelöst, bei dem die Modulation mit Tiefpaß-Übertragungsverhalten in einem Frequenzteiler im Rückführungszweig der PLL-Schaltung digital erfolgt.

Erfindungsgemäß ist es dabei besonders bevorzugt, daß als Frequenzteiler ein multi-modulus-Teiler verwendet wird. Dadurch ist es möglich, ganzzahlige Vielfache von $2\pi$ von der Phase des spannungsgesteuerten Oszillators abzuziehen, bzw. zu addieren (Pulse Swallowing-Prinzip).

Weiter ist es dabei besonders bevorzugt, das Modulationssignal vor der Ansteuerung des Frequenzteilers einer Delta-Sigma-Modulation zu unterwerfen bzw. einen Delta-Sigma-Modulator zwischen Modulationssignal und Frequenzteiler anzuordnen. Dadurch können auch sehr feine Quantisierungsstufen der eingebrachten Phase erreicht werden. Weiter erfolgt die Modulation mit Hochpaß-Übertragungsverhalten vorzugsweise durch Summation des modulierenden Signals mit dem Signal zwischen Schleifenfilter und spannungsgesteuertem Oszillator. Zu diesem Zweck erfolgt die Modulation mit Hochpaß-Übertragungsverhalten vorzugsweise an einem Summationspunkt, der zwischen Schleifenfilter und spannungsgesteuertem Oszillator angeordnet ist. Hierbei kann auch eine analoge Verarbeitung erfolgen, da durch die Hochpaßcharakteristik an diesem Punkt Toleranzprobleme und Drift-Probleme reduziert werden.

Die vorliegende Erfindung wird im folgenden anhand des in den beiliegenden Zeichnungen dargestellten Ausführungsbeispiels näher erläutert. Es zeigen:

Figur 1 die gemäß dem Stand der Technik möglichen Punkte zur Einbringung einer Modulation in eine PLL; und

Figur 2 einen erfindungsgemäßen Zwei-Punkt-Modulator.

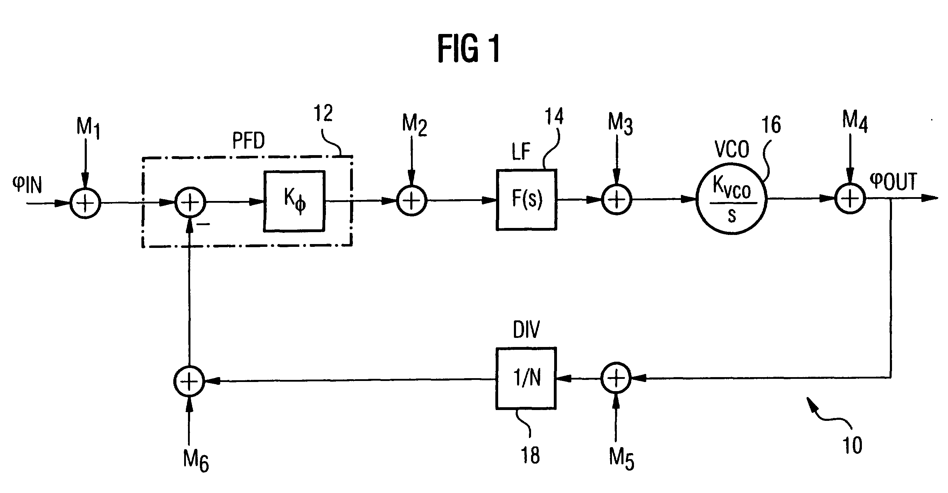

Zum besseren Verständnis der Erfindung soll zuerst der Stand der Technik anhand der Figur 1 näher erläutert werden. Die Figur 1 zeigt eine PLL-Schaltung 10. Diese besitzt einen Eingang für das Eingangssignal $\varphi_{IN}$. Dieser führt zum Phasendetektor 12, an den Phasendetektor 12 ist der Schleifenfilter 14 und an diesem ein spannungsgesteuerter Oszillator (VCO) 16 angeschlossen. Der Ausgang des spannungsgesteuerten Oszillators liefert das Ausgangssignal $\varphi_{OUT}$. Dieses Ausgangssignal wird gleichzeitig über einen Teiler 18 an den Phasendetektor 12 zurückgeliefert. Dort wird die Differenz zwischen Eingangs- und Ausgangssignal gebildet, womit sich der Regelkreis schließt.

Wenn eine solche PLL-Schaltung 10 (Phase Locked Loop, zu deutsch Nachlaufsynchronisation) zur Phasen- oder Frequenzmodulation verwendet werden soll, gibt es prinzipiell verschiedene Punkte in der PLL-Schaltung 10, an denen man das Modulationssignal in die Schleife der PLL einbringen kann. Diese möglichen Punkte zur Einbringung der Modulation in die PLL sind in Figur 1 dargestellt und mit den Bezugszeichen M1 bis M6 bezeichnet.

Der Einspeisepunkt M1 führt zu einer Addition des Modulations-Signals zum Eingangssignal $\varphi_{IN}$, der Ein-

speisungspunkt M2 liegt zwischen Phasendetektor 12 und Schleifenfilter 14, der Einspeisungspunkt M3 liegt zwischen Schleifenfilter 14 und spannungsgesteuertem Oszillator 16, der Einspeisungspunkt M4 liegt vor der Abzweigung des Rückführzweiges zum Teiler 18 und beeinflußt damit das Ausgangssignal $\varphi_{OUT}$, der Einspeisepunkt M5 liegt vor dem Teiler 18 im Rückführzweig und der Einspeisepunkt M6 liegt zwischen dem Teiler 18 und dem Phasendetektor 12.

Mathematisch ergeben sich an diesen Punkten die folgenden Übertragungsfunktionen:

$$\text{für } M1: \frac{\varphi_{out}}{M_1} = N \frac{1}{1 + \dfrac{s}{F(s)} \dfrac{N}{K_\phi K_{VCO}}}$$

$$\text{für } M2: \frac{\varphi_{out}}{M_2} = \frac{N}{K_\phi} \frac{1}{1 + \dfrac{s}{F(s)} \dfrac{N}{K_\phi K_{VCO}}}$$

$$\text{für } M3: \frac{\varphi_{out}}{M_3} = \frac{K_{VCO}}{s} \frac{1}{1 + \dfrac{F(s)}{s} \dfrac{K_\phi K_{VCO}}{N}}$$

$$\text{für } M4: \frac{\varphi_{out}}{M_4} = \frac{1}{1 + \dfrac{F(s)}{s} \dfrac{K_\phi K_{VCO}}{N}}$$

$$\text{für } M5: \frac{\varphi_{out}}{M_5} = \frac{1}{1 + \dfrac{s}{F(s)} \dfrac{N}{K_\phi K_{VCO}}}$$

$$\text{für } M6: \frac{\varphi_{out}}{M_6} = N \frac{1}{1 + \dfrac{s}{F(s)} \dfrac{N}{K_\phi K_{VCO}}}$$

Interessant ist dabei, daß sich für eine Einbringung der Modulation bei M3 und M4 ein Hochpaß-Übertragungsverhalten der PLL ergibt, während bei Einbringung der Modulation an M1, M2, M5 und M6 ein Tiefpaß-Übertragungsverhalten auftritt. Verwendet man also einen der Tiefpaß-Punkte (M1, M2, M5 oder M6) der PLL zum Einspeisen der Modulation, dann wird das Modulationssignal mit einer Tiefpaß-Funktion bewertet. Dies schränkt die Modulationsbandbreite im Allgemeinen auf kleiner als die PLL-Bandbreite ein. Verwendet man den Hochpaßpunkt M3 (für M4 ist noch keine Technik zum Einbringen einer Modulation bekannt), dann werden die Tiefen-Frequenzen des Modulationsspektrums abgeschwächt, was im Allgemeinen zu einer nicht akzeptierbaren Verschlechterung der Modulationsqualität führt.

Aus dem Stand der Technik, beispielsweise den o.g. Entgegenhaltungen, ist bereits eine Möglichkeit bekannt, die es erlaubt, eine PLL mit Signalen, die eine Bandbreite größer als die PLL-Bandbreite besitzen, zu modulieren. Dieses Verfahren wird als Zwei-Punkt-Modulation bezeichnet. Dabei wird an zwei Punkten der PLL, an einem Hochpaß- und einem Tiefpaßpunkt, die Modulation eingebracht. Die beiden Modulationssignale überlagern sich am Ausgang der PLL und man erhält auf diese Weise ein frequenzunabhängiges Übertragungsverhalten der PLL. Das Problem bei den bisherigen Lösungen beruhte in der Einbringung des Signals an einem Tiefpaßpunkt. Hierfür war analoge Schaltungstechnik zur Signalbearbeitung notwendig. Damit verbunden waren Toleranzprobleme bei der Fertigung und Driftprobleme mit der Temperatur und der Alterung. Diese Driften und Toleranzen wurden durch die PLL nicht wie beim Hochpaßpunkt reduziert, da eine Tiefpaß-Charakteristik gegen solche niederfrequenten oder gar Gleichstromdriften leider sehr empfindlich ist.

Erfindungsgemäß wird daher eine solche Zwei-Punkt-Modulation dergestalt weiterentwickelt, daß das Signal digital am Tiefpaßpunkt M5 der PLL eingebracht wird. Durch die Verwendung digitaler Techniken können dabei die Probleme mit Toleranzen und Driften vermieden werden. Außerdem kann erfindungsgemäß eine wesentlich genauere Sollwertvorgabe für die niederfrequenten Anteile des modulierenden Signals erreicht werden. Erfindungsgemäß wird dazu vorzugsweise in der Rückführungsschleife der PLL ein multi-modulus-Teiler verwendet. Dieser erlaubt es, ganzzahlige Vielfache von $2\pi$ von der Phase des spannungsgesteuerten Oszillators (VCO) abzuziehen, bzw. dazu zu addieren (Pulse Swallowing Prinzip). Die Quantisierung der eingebrachten Phase auf Vielfache von $2\pi$ stellt dabei keine Einschränkung der Verwendbarkeit dar, wenn man für die Ansteuerung des multi-modulus-Teilers Delta-Sigma-Techniken, wie sie bei den Digital-analog bzw. Analog-digital-Wandlern eingesetzt werden, verwendet. Damit kann man erfindungsgemäß einen Zwei-Punkt-Modulator realisieren, der als Hochpaßpunkt M3 und als Tiefpaßpunkt M5 bzw. direkt den Teiler 18 selbst verwendet.

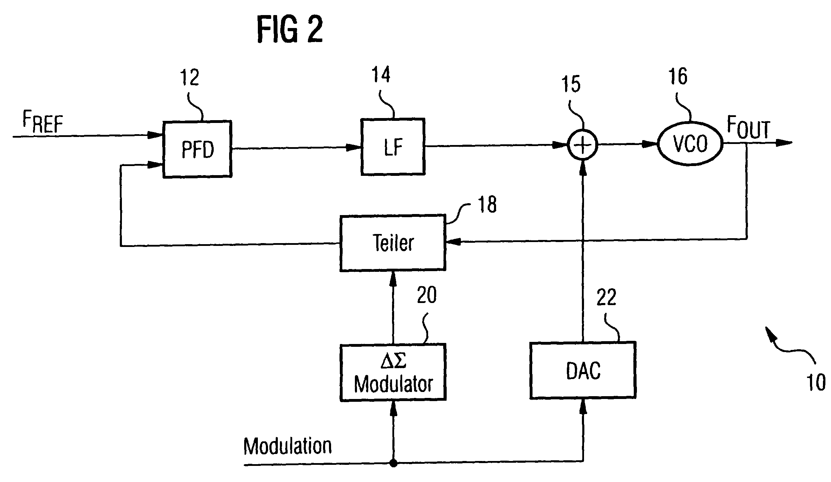

Figur 2 zeigt ein Auführungsbeispiel der Erfindung. Im rückläufigen Zweig der PLL-Schleife befindet sich erfindungsgemäß ein multi-modulus-Teiler 18. Dieser teilt die Frequenz an seinem Eingang durch $(N+\Delta N)$. Dies kann auch betrachtet werden, als ein Teilen durch N und ein Verschlucken von $\Delta N$-Eingangsimpulsen bzw. ein Hinzufügen von $\Delta N$-Eingangsimpulsen bei negativen $\Delta N$. Da ein Eingangsimpuls einer Phase von $2\pi$ beim spannungsgesteuerten Oszillator entspricht, bietet ein multi-modulus-Teiler die Möglichkeit, Vielfache von $2\pi$ perfekt zur VCO-Phase zu addieren bzw. zu subtrahieren. Für Modulationszwecke benötigt man aber im Allgemeinen wesentlich feinere Quantisierungsstufen der eingebrachten Phase. Dies kann, wie oben bereits dargestellt, leicht dadurch erreicht werden, daß man das Modulationssignal vor Ansteuerung des Teilers einer Delta-Sigma-Modulation unterwirft, bzw. zwischen den Modulationssignal und den multi-modulus-Teiler 18 einen Delta-Sigma-Modulator 20 schaltet.

Es ergibt sich dann die in Figur 2 dargestellte Schaltung. Die PLL-Schaltung 10 besteht wie üblich aus dem Phasen-Detektor (PFD) 12, dem die Referenzfrequenz $F_{REF}$ zugeführt wird. An diesen schließt sich das Schleifenfilter (LF) 14 an. Der Ausgang des Schleifenfilters 14 ist mit einem Summationspunkt 15 verbunden. Dieser Summationspunkt 15 weist eine Hochpaßcharakteristik in der Übertragung des dort eingeschleiften Modulationssignals auf. Der Ausgang des Summationspunktes 15 ist mit dem spannungsgesteuerten Oszillator (VCO) 16 verbunden, dessen Ausgang die Ausgangsfrequenz ($F_{OUT}$) liefert. Die Ausgangsfrequenz ($F_{OUT}$) wird über den Teiler 18 an den Phasendetektor 12 und damit an den Eingang der Schleife zurückgeführt. Erfindungsgemäß ist der Teiler 18 hier als multi-modulus-Teiler ausgeführt, der durch $N+\Delta N$ teilt. Das Signal $\Delta N$ wird dabei über einen Delta-Sigma-Modulator 20 zugeführt, der mit dem Modulationseingangssignal verbunden ist. Gleichzeitig wird das Modulationseingangssignal über einen Digital-Analog-Wandler (DAC) 22 dem Summationspunkt 15 zugeführt. Die Signalverarbeitung kann an diesem Summationspunkt 15 problemlos analog erfolgen, da dieser Summationspunkt eine Hochpaßcharakteristik aufweist, und daher gegen Toleranzen und Drift, die ja extrem niederfrequent bzw. reine Gleichstromanteile sind, unempfindlich ist.

**Patentansprüche**

1. Modulator zur Phasen- oder Frequenzmodulation mit einer PLL (Phase Locked Loop = Nachlaufsynchronisation) - Schaltung (10), wobei die Modulation sowohl an einem Punkt (M3) der PLL-Schaltung (10) erfolgt, an dem sich ein Hochpaß-Übertragungsverhalten für die Modulationsfrequenz ergibt, als auch zusätzlich an einem weiteren Punkt (M5) der PLL-Schaltung (10) erfolgt, an dem sich ein Tiefpaß-Übertragungsverhalten für die Modulationsfrequenz ergibt, **dadurch gekennzeichnet**, daß die Modulation mit Tiefpaß-Übertragungsverhalten in einem Frequenzteiler (18) im Rückführungszweig der PLL-Schaltung (10) digital erfolgt.

2. Modulator nach Anspruch 1, **dadurch gekennzeichnet**, daß als Frequenzteiler (18) ein multimodulus-Teiler vorgesehen ist.

3. Modulator nach Anspruch 1 oder 2, **dadurch gekennzeichnet**, daß ein Delta-Sigma-Modulator (20) zwischen Modulationssignal und Frequenzteiler (18) angeordnet ist.

**4.** Modulator nach einem der Ansprüche 1 bis 3, **dadurch gekennzeichnet**, daß die Modulation mit HochpaßÜbertragungsverhalten an einem Summationspunkt (15) erfolgt, der zwischen Schleifenfilter (14) und spannungsgesteuertem Oszillator (16) angeordnet ist.

**5.** Verfahren zur Phasen- oder Frequenzmodulation mit einer PLL (Phase Locked Loop = Nachlaufsynchronisation) - Schaltung (10), wobei die Modulation sowohl an einem Punkt (M3) der PLL-Schaltung (10) erfolgt, an dem sich ein Hochpaß-Übertragungsverhalten für die Modulationsfrequenz ergibt, als auch zusätzlich an einem weiteren Punkt (M5) der PLL-Schaltung (10) erfolgt, an dem sich ein Tiefpaß-Übertragungsverhalten für die Modulationsfrequenz ergibt, **dadurch gekennzeichnet**, daß die Modulation mit Tiefpaß-Übertragungsverhalten in einem Frequenzteiler (18) im Rückführungszweig der PLL-Schaltung digital erfolgt.

**6.** Verfahren nach Anspruch 5, **dadurch gekennzeichnet**, daß als Frequenzteiler (18) ein multimodulus-Teiler verwendet wird.

**7.** Verfahren nach Anspruch 5 oder 6, **dadurch gekennzeichnet**, daß das Modulationssignal vor der Ansteuerung des Frequenzteilers (18) einer Delta-Sigma-Modulation unterworfen wird.

**8.** Verfahren nach einem der Ansprüche 5 bis 7, **dadurch gekennzeichnet**, daß die Modulation mit Hochpaß-Übertragungsverhalten durch Summation des modulierenden Signals mit dem Signal zwischen Schleifenfilter (14) und spannungsgesteuertem Oszillator (16) erfolgt.

# FIG 1

EP 1 063 766 A2

# FIG 2